# EUROPEAN PATENT APPLICATION

(11) **EP 3 993 010 A1**
(43) Date of publication of application: **04.05.2022**
(21) Application number: 20831890.7
(22) Date of filing: 25.06.2020
(51) Int. Cl.: H01L 21/02, H01L 21/301, H01S 5/02

(54) **LAYERED BODY AND LAYERED BODY PRODUCTION METHOD**

(30) Priority: 26.06.2019 JP 2019119035
(71) Applicant: Kyocera Corporation, Kyoto-shi, Kyoto 612-8501 (JP)
(72) Inventor: MURAKAWA, Kentaro, Kyoto-shi, Kyoto 612-8501 (JP); MASAKI, Katsuaki, Kyoto-shi, Kyoto 612-8501 (JP)
(74) Representative: TBK
(86) International application number: PCT/JP2020/025107
(87) International publication number: WO 2020/262560

(57) **Abstract**

Included are: an underlying substrate including a first surface; a semiconductor element layer dividable into a plurality of element portions, the semiconductor element layer being located on the first surface of the underlying substrate; and a support substrate including a second surface on which the semiconductor element layer is located, the second surface facing the first surface, the semiconductor element layer being located on the second surface. The support substrate and the semiconductor element layer include a weak portion used to divide the semiconductor element layer into the plurality of element portions.

## Description

### Cross-reference to related applications

The present application claims priority based on Japanese Patent Application No. 2019-119035 filed in Japan on June 26, 2019, and the entire disclosure of which is incorporated herein by reference.

### Technical Field

The present disclosure relates to a layered body before being divided into individual pieces of a plurality of semiconductor elements, and a manufacturing method for the layered body.

### Background Art

Typically, a mask layer including a strip-shaped mask pattern is formed on a first surface that is a crystal growth surface of an underlying substrate. After this, a GaN layer is caused to grow from a bottom surface (first surface exposed from a window region) of the window region of the mask layer by selective growth. In addition, the GaN layer is caused to grow in a lateral direction on the mask layer to form a semiconductor element layer. A technique of manufacturing semiconductor elements has been known. In this technique, a support substrate is bonded to this semiconductor element layer. While the semiconductor element layer is being peeled off from the underlying substrate, the support substrate is divided into individual pieces or individual chips to manufacture the semiconductor elements. For example, Patent Document 1 describes such a known technique.

### Citation List

### Patent Literature

Patent Document 1: JP No. 2009-253062 A

### Summary

A layered body of the present disclosure may include:
an underlying substrate including a first surface;
a semiconductor element layer that is a single semiconductor element layer dividable into a plurality of element portions, the semiconductor layer being located on the first surface of the underlying substrate; and
a support substrate including a second surface on which the semiconductor element layer is located, the second surface facing the first surface, in which
the support substrate and the semiconductor element layer include a weak portion used to divide the semiconductor element layer into the plurality of element portions.

In addition, a layered body of the present disclosure may include:
an underlying substrate including a first surface;
a semiconductor element layer that is a single semiconductor element layer dividable into a plurality of element portions, the semiconductor element layer being located on the first surface of the underlying substrate; and
a support substrate including a second surface on which the semiconductor element layer is located, the second surface facing the first surface, in which
the semiconductor element layer includes a weak portion used to divide the semiconductor element layer 13 into the plurality of element portions, and
the support substrate includes a plurality of support substrate portions that do not face the weak portion W.

In addition, a semiconductor device of the present disclosure may include:
the layered body; and
an electrode portion located at each of the plurality of element portions of the layered body.

In addition, a manufacturing method for a layered body of the present disclosure may include:
preparing an underlying substrate including a first surface;
preparing a support substrate including a second surface that faces the first surface;
forming, on the first surface of the underlying substrate, a semiconductor element layer that is a single semiconductor element dividable into a plurality of element portions;
bonding the second surface of the support substrate to the semiconductor element layer formed in the forming the single semiconductor element layer; and
forming a weak portion used to divide the semiconductor element layer into the plurality of element portions, at each of the semiconductor element layer and the support substrate that are bonded in the bonding the second surface.

### Brief Description of Drawings

The objects, features, and advantages of the present invention will become more apparent from the following detailed description and drawings.
FIG. 1 is a cross-sectional view illustrating a state in which a mask layer is formed on a first surface of an underlying substrate of a layered body of an embodiment of the present disclosure.
FIG. 2 is a cross-sectional view illustrating a state in which a semiconductor element layer is formed on the underlying substrate where the mask layer of the present disclosure has been formed.
FIG. 3 is a cross-sectional view illustrating a state in which a protective layer is formed at a target object after a light emitting layer is formed.
FIG. 4 is a cross-sectional view illustrating a state in which a metal layer is formed at the target object after a protective layer is formed.
FIG. 5 is a cross-sectional view illustrating a state in which the mask layer is removed from the target object after the metal layer is formed.
FIG. 6 is a cross-sectional view illustrating a state in which a support substrate is disposed on the target object after the mask layer is removed.
FIG. 7 is a cross-sectional view illustrating a state in which the underlying substrate is removed from the target object to which the support substrate has been bonded.
FIG. 8 is a cross-sectional view illustrating a state in which a damaged layer is removed from the target object from which the underlying substrate has been removed.
FIG. 9 is a cross-sectional view illustrating a state in which a metal layer is formed at the target object from which the damaged layer has been removed.
FIG. 10 is a cross-sectional view illustrating the target object as viewed from a cross-sectional line X-X in FIG. 9.
FIG. 11 is a bottom view illustrating the target object from which the damaged layer has been removed, as viewed from below in FIG. 10.
FIG. 12 is a cross-sectional view illustrating a state in which a weak portion is formed at the target object at which the metal layer has been formed.
FIG. 13 is a cross-sectional view illustrating a semiconductor element obtained by cleaving, at the weak portion, the target object having the weak portion formed therein and dividing it into individual pieces.
FIG. 14 is a cross-sectional view illustrating a state in which a protective layer is formed at an end surface of the semiconductor element divided into a plurality of individual pieces.
FIG. 15 is a cross-sectional view illustrating a layered body of another embodiment of the present disclosure.
FIG. 16 is a cross-sectional view illustrating a layered body of yet another embodiment of the present disclosure.
FIG. 17 is a cross-sectional view illustrating a layered body of yet another embodiment of the present disclosure.

### Description of Embodiments

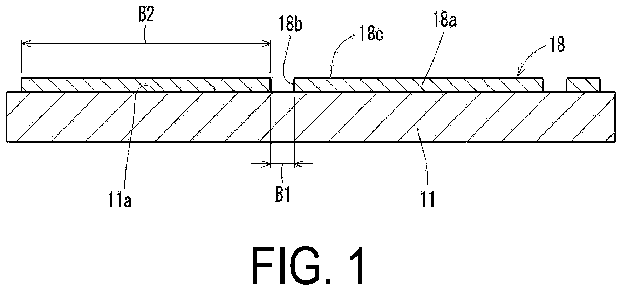

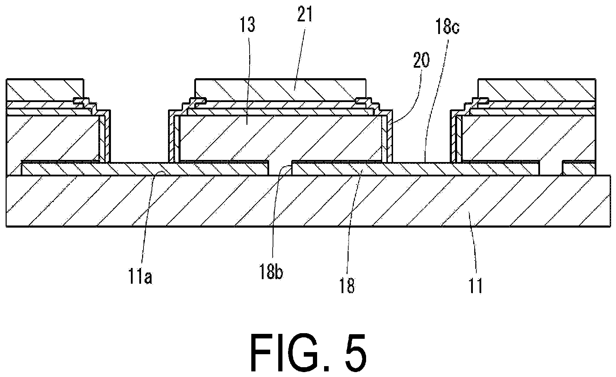

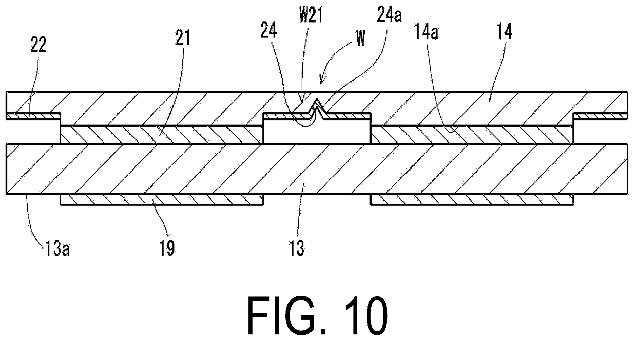

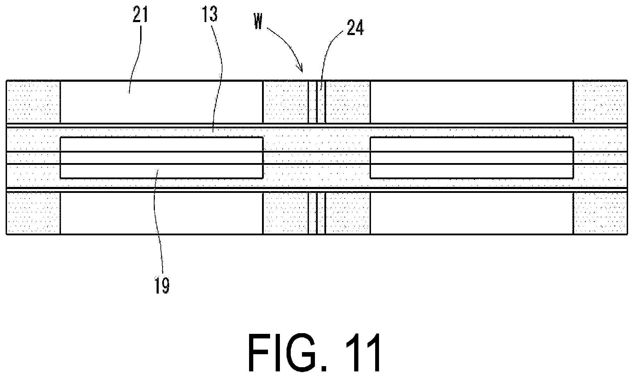

Embodiments of a layered body of the present disclosure and a manufacturing method for this layered body will be described with reference to FIGS. 1 to 16 that are schematically illustrated.

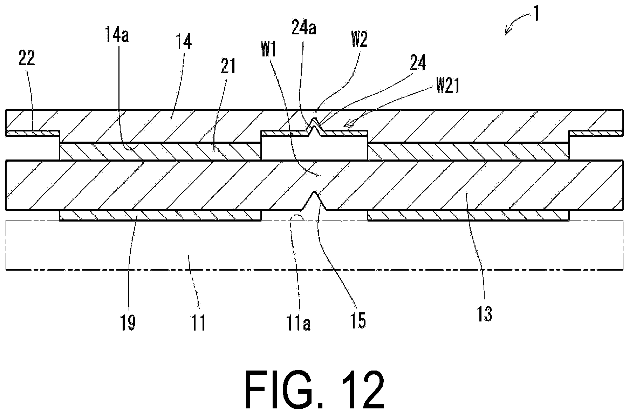

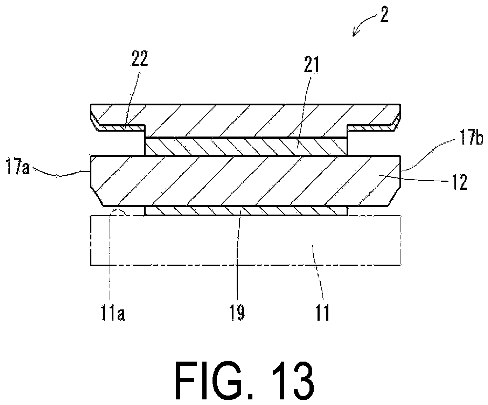

FIGS. 1 to 13 are cross-sectional views for explaining a procedure of manufacturing a layered body of an embodiment of the present disclosure. First, a configuration of a layered body 1 of the present embodiment will be described with reference to FIGS. 12 and 13.

FIG. 12 is a cross-sectional view illustrating the layered body 1 of the embodiment of the present disclosure. FIG. 13 is a cross-sectional view illustrating a divided piece 2 obtained by dividing the layered body 1 into individual pieces. The layered body 1 of the present embodiment includes: an underlying substrate 11 including a first surface 11a; a single semiconductor element layer 13 located on the first surface 11a of the underlying substrate 11 and dividable into a plurality of element portions 12; and a support substrate 14 including a second surface 14a on which the semiconductor element layer 13 is located, the second surface 14a facing the first surface 11a. The semiconductor element layer 13 includes a first weak portion W1 used to divide the semiconductor element layer 13 into individual pieces of the plurality of element portions 12. The support substrate 14 includes a second weak portion W2 formed at a location that faces, in a plane, the first weak portion W1 of the semiconductor element layer 13.

The weak portions W1 and W2 respectively include recessed portions 15, 24 such as notches. Such weak portions W1 and W2 can be created, for example, by a laser scribing method, etching, or the like after the semiconductor element layer 13 to which the support substrate 14 is bonded is peeled off from the underlying substrate 11. Specifically, the recessed portions 15, 24 such as notches that extend in a direction (for example, in a perpendicular direction: in a direction perpendicular to the paper surface of FIG. 12) intersecting a resonance direction that is a left-right direction in FIG. 12 are each formed, which makes it possible to form the weak portions that continuously extend in this direction. In another embodiment, the weak portions W1 and W2 may be intermittently formed at a plurality of locations with a gap being provided in a direction intersecting the resonance direction.

Here, a typical manufacturing process is performed such that a support substrate for transfer is bonded to a semiconductor element layer formed on an underlying substrate to obtain a layered body, and the layered body is divided into a plurality of semiconductor elements. In this manufacturing process, it is considered that the layered body is not easy to be divided precisely while matching, in a plane, the location of a starting point of cleavage at the semiconductor element layer and the location of a starting point of separation of the support substrate. In this manner, there is room for improvement in productivity of a semiconductor element.

In contrast, in a case of the layered body of the present disclosure, the layered body 1 is configured such that the semiconductor element layer 13 and the support substrate 14 include the weak portions W1, W2. With this configuration, the semiconductor element layer 13 and the support substrate 14 can be divided at the same time at a facing location (for example, the same location in a plane) in a plane to easily and precisely divide the layered body 1 into individual pieces, thereby creating a plurality of element portions 12. In addition, by dividing the layered body 1, the support substrate 14 and the semiconductor element layer 13 are cleaved at the same time, and cleavage surfaces 17a and 17b are formed at respective element portions 12. With this configuration, the number of processes and the number of occurrences of defective parts having a defect at the cleavage surfaces 17a and 17b serving as division planes can be reduced, thereby improving yield and productivity, as compared with a case where the support substrate 14 and the semiconductor element layer 13 are separately divided. These cleavage surfaces 17a and 17b can be used as a resonator surface.

A method for manufacturing the layered body 1 described above will be described below. The layered body of the present embodiment includes an underlying-substrate preparation step, a support-substrate preparation step, an element-layer formation step, an element-layer bonding step, and a weak-portion formation step.

The underlying-substrate preparation step includes preparing the underlying substrate 11 including the first surface 11a. The support-substrate preparation step includes preparing the support substrate 14 including the second surface 14a that faces the first surface 11a. The element-layer formation step includes forming, on the first surface 11a of the underlying substrate 11, a single semiconductor element layer 13 dividable into the plurality of element portions 12. The element-layer bonding step includes bonding the second surface 14a of the support substrate 14 to the semiconductor element layer 13 formed in the element-layer formation step. The weak-portion formation step includes forming the weak portions W1 and W2 used to divide the semiconductor element layer 13 into individual pieces of the plurality of element portions 12 at the semiconductor element layer 13 and the support substrate 14 that have been bonded together in the element-layer bonding step.

The weak portions W1 and W2 of the present embodiment are formed so as to continuously extend in a direction (for example, in a perpendicular direction: a direction perpendicular to the paper surface of FIG. 12) intersecting a resonance direction. However, in other embodiments of the present disclosure, the weak portions W1 and W2 may be formed so as to intermittently extend in a direction (for example, in a perpendicular direction) intersecting a resonance direction and at a plurality of locations with a gap between them. In addition, the second weak portion W2 of the present embodiment includes a thin portion including a recessed portion 24. However, the second weak portion W2 may include only the recessed portion 24. Furthermore, the weak portions W1 and W2 may be arranged only in a direction intersecting the resonance direction.

The order of the underlying-substrate preparation step and the support-substrate preparation step is not necessarily limited to this order. For example, the underlying-substrate preparation step and the support-substrate preparation step may be performed in parallel with each other, or the underlying-substrate preparation step may be performed after the support-substrate preparation step. For example, a semiconductor laser, a light emitting diode, a photodiode, a Schottky diode, or the like can be used for the semiconductor element. However, no such limitation is intended.

Next, the procedure of manufacturing the layered body 1 will be specifically described with reference to FIGS. 1 to 13.

As illustrated in FIG. 1, the underlying substrate 11 is prepared in the underlying-substrate preparation step. A (0001) face where a crystal is easily grown is used as the first surface 11a of the underlying substrate 11, and a crystal growth surface lattice-matched with the first surface 11a is required for the underlying substrate 11. Thus, for the underlying substrate 11, a GaN template substrate obtained by causing GaN to grow on hetero underlying crystal of a sapphire substrate, a GaAs substrate, or the like is used, for example. A GaN substrate cut out from a GaN single crystal ingot can be used for the underlying substrate with the crystal growth surface being in a predetermined surface direction. As the underlying substrate 11, any nitride semiconductor substrate may be used. In addition, the underlying substrate 11 may be an n-type semiconductor substrate in which impurities are doped in a nitride semiconductor or may be a p-type semiconductor substrate.

Next, a mask layer 18 is formed on the first surface 11a of the underlying substrate 11. First, for example, silicon dioxide (SiO₂) or the like serving as a material for mask is deposited by approximately from 10 nm to 500 nm on the first surface 11a of the underlying substrate 11 using a plasma chemical vapor deposition (PCVD) method or the like.

Subsequently, the SiO₂ layer is patterned by a photolithography method and wet etching with buffered hydrogen fluoride (BHF) to form the mask layer 18 illustrated in FIG. 1. The mask layer 18 has a stripe shape in which a plurality of strip-shape portions 18a are arranged in parallel with a predetermined gap.

The width B1 of an opening portion 18b between adjacent strip-shape portions 18a falls in a range, for example, from approximately 2 µm to 20 µm, and preferably, may be approximately 5 µm. In addition, the width B2 of the strip-shape portion 18a falls in a range, for example, from approximately 50 µm to 1000 µm, and preferably, may be 165 µm.

In addition to SiO₂, examples of the mask material for selectively forming the mask layer 18 include an amorphous material that does not allow a semiconductor layer to grow from the front surface of the mask by vapor phase growth. For the mask material, an amorphous material that can be patterned, namely, oxide such as ZrOx, TiOx, or AlOx, nitride such as SiNx, or transition metal such as W or Cr can be used. For the method for depositing the mask layer 18, a method appropriate for the mask material such as vapor deposition, a sputtering method, or coating-cure can be used.

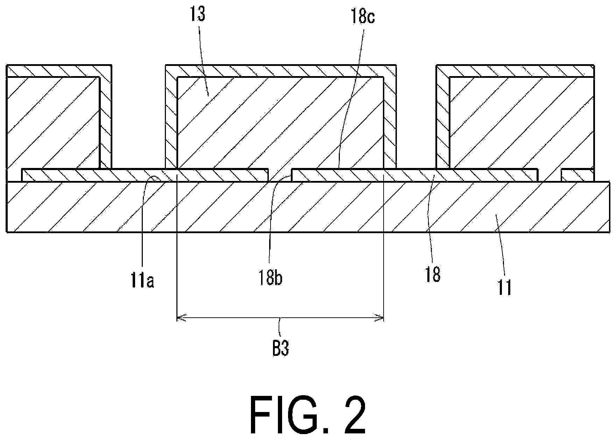

FIG. 2 is a cross-sectional view illustrating a state in which the semiconductor element layer 13 is formed at a target object where the mask layer 18 is formed on the underlying substrate 11. In the element-layer formation step, an epitaxial lateral overgrowth (ELO) method is used to deposit a GaN semiconductor on the underlying substrate 11 where the mask layer 18 has been formed in the underlying-substrate preparation step described above, and to form the semiconductor element layer 13.

Such a semiconductor element layer 13 and the first surface 11a serving as a crystal growth surface of the underlying substrate 11 are covered with SiO₂ that is amorphous. This configuration makes misfit dislocation of the underlying substrate 11 less likely to occur, and makes it possible to form the semiconductor element layer 13 by selective lateral growth (epitaxial lateral overgrowth; ELO) from the crystal growth surface of the first surface 11a exposed to the opening portion 18b that is also called a window. For example, a nitride-based semiconductor is used for the material of the semiconductor element layer 13.

As a method of crystal growth, chloride vapor phase epitaxy (VPE) through chloride transport method using chloride as a group III element of a raw material, a metal organic chemical vapor deposition (MOCVD) method using an organic metal as a group III element of a raw material, or a hydride vapor phase epitaxy (HVPE) method can be used. During growth steps, the percentage of raw material gases of the group III elements, the percentage of impurities to the raw material gas, or the like is changed to form the semiconductor element layer 13 with a multi-layer film that constitutes a light emitting layer such as a light emitting diode (LED) or LD.

For example, n+ type GaN in which Si is doped as n-type impurities is grown in an island manner in a (0001) face orientation from the first surface 11a serving as a crystal growth surface of the underlying substrate 11 by the MOCVD method. For example, for growth of this n+ type GaN layer, TMG and NH₃ can be used as raw material gas, H₂ and N₂ can be used as carrier gas, and SiH₄ diluted with nitrogen, which serving as n-type dopant, can be used.

When the crystal that epitaxially grows in the opening portion 18b extends beyond the opening portion 18b of the mask layer 18, the crystal also grows in a lateral direction along the upper surface 18c of the mask layer 18. The crystal growth ends before the semiconductor element layer 13 that has grown from the first surface 11a in the opening portion 18b overlaps an adjacent semiconductor element layer 13. In this manner, the n + type GaN layer is caused to grow by ELO.

Next, conditions for crystal growth are adjusted to cause the n-type GaN layer to grow on the n + type GaN layer using a MOCVD method. In addition, for example, an LD layer is caused to grow, whereby the semiconductor element layer 13 is formed for each opening portion 18b. For example, after an insulation film made of SiO₂ is caused to grow by a plasma CVD method, the insulation film is patterned in a predetermined shape using photolithography and etching to cause the LD layer to be exposed.

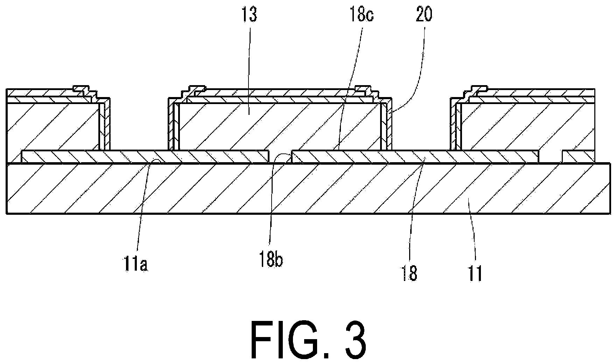

As illustrated in FIG. 3, a protective layer 20 including a layer containing aluminum oxide, alumina, or the like is formed on a side surface of the semiconductor element layer 13 that has been formed in the element-layer formation step described above. In a case where such a protective layer 20 is not provided, the semiconductor element layer 13 including a light emitting layer is gradually thermally decomposed, and is more likely to alter. Thus, thermal emissivity and in-plane distribution of the thermal emissivity occur at the interior of the semiconductor element layer 13. This makes the growth conditions of semiconductor crystal more likely to deviate from optimum conditions, which causes a reduction in mass productivity.

In a case where the protective layer 20 is provided on the side surface of the semiconductor layer13 as in the present embodiment, the semiconductor element layer 13 is less likely to alter, the semiconductor crystal can be stably grown, and the mass productivity can be maintained. However, such a protective layer 20 is not essential, and may not be provided.

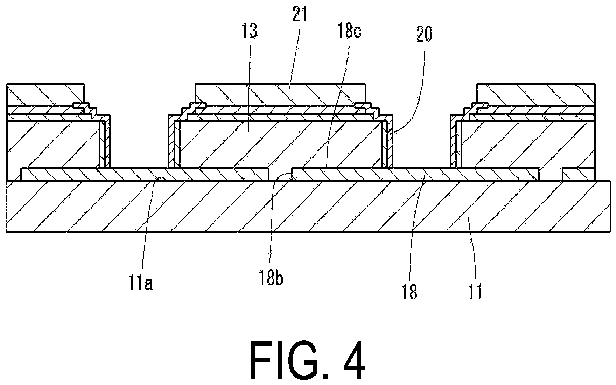

As illustrated in FIG. 4, at the target object where the protective layer 20 has been formed in the previous step, an unnecessary metal layer together with a resist film is removed by evaporation and lift-off method, to form an electrode pad 21. The thickness of this electrode pad 21 falls in a range approximately from 1 µm to 5 µm. Such an electrode pad 21 can be formed, for example, by a lift-off method.

First, resist is applied to the semiconductor element layer 13, and the resist is patterned by photolithography. Then, for example, Ti, Au, or other metals serving as a material of the electrode pad 21 is vapor-deposited, and the resist is removed (lift-off process). Through these steps, the electrode pad 21 is formed at the semiconductor element layer 13. However, patterning of the electrode pad 21 described above can be performed, for example, by vapor-depositing using a metal mask.

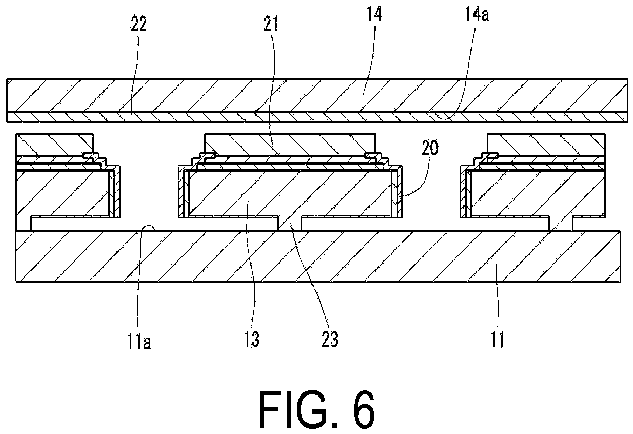

FIG. 6 is a cross-sectional view illustrating a state in which the support substrate 14 is disposed so that the second surface 14a faces the first surface 11a of the underlying substrate 11. In the support-substrate preparation step, a joint layer 22 made of solder using an alloy such as AuSn or metal such as Au is formed on the second surface 14a of the support substrate 14 that faces the first surface 11a serving as the crystal growth surface of the underlying substrate 11.

By using the support substrate 14 or a jig or the like, the semiconductor element layer 13 is separated from the underlying substrate 11 and is divided into individual pieces of the plurality of element portions 12. For example, as the technique for separation, the support substrate 14 including the joint layer 22 on the second surface 14a is caused to face the first surface 11a of the underlying substrate 11, and the joint layer 22 is pressurized against the semiconductor element layer 13 and is heated to bond them together. After this, external force is applied in a manner such that the semiconductor element layer 13 integrally bonded to the support substrate 14 with the joint layer 22 therebetween is torn off in the upper direction, that is, in a direction away from the underlying substrate 11 to take the semiconductor element layer 13 off from the first surface 11a of the underlying substrate 11. This makes it possible to separate the semiconductor element layer 13 from the underlying substrate 11 without damaging it. Note that, at the time of bonding the joint layer 22 to the semiconductor element layer 13, the electrode pad 21 and the joint layer 22 may be integrated.

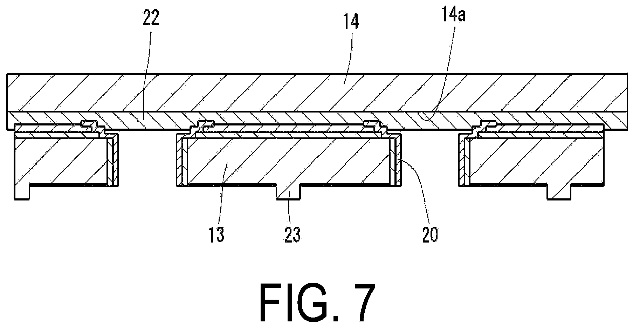

FIG. 7 is a cross-sectional view illustrating a state in which the underlying substrate 11 is removed from each element portion 12 to which the support substrate 14 is bonded. After the support substrate 14 is bonded to each element portion 12 as described above, each of the element portions 12 together with the support substrate 14 is peeled off from the underlying substrate 11. For example, ultrasound is emitted onto the underlying substrate 11 and each element portion 12 that have been integrated, or mechanical force such as vibration is caused to act on the underlying substrate 11 and the support substrate 14. In this manner, each element portion 12 may be peeled off from the underlying substrate 11 at a position between the underlying substrate 11 and a connection portion 23 of each element portion 12.

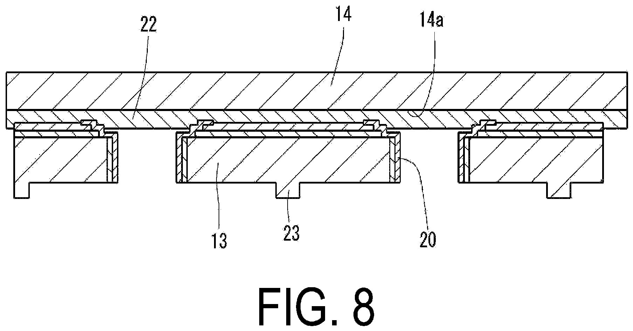

FIG. 8 is a cross-sectional view illustrating a state in which a damaged layer is removed from the target object from which the underlying substrate 11 has been removed. Since each element portion 12 is peeled off from the underlying substrate 11, each connection portion 23 is broken. Such a connection portion 23 may remain at the underlying substrate 11 side or the element portion 12 side or both of them, depending on the situation of breakage. Thus, after peeling off, the fragments of the connection portion 23 remaining at the underlying substrate 11 and each element portion 12 may be removed by polishing or an etching method and the damaged layer may be removed.

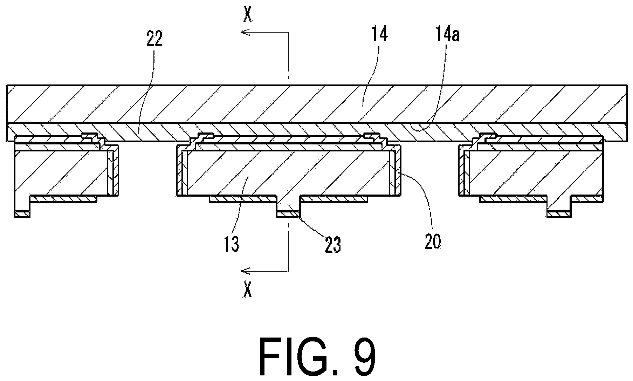

Next, the present embodiment will be described with reference to FIGS. 9 to 12.

In the support substrate 14, a recessed portion 24 (first recessed portion 24) such as a notch extending in a direction (for example, perpendicular direction) intersecting a resonance direction is formed between two adjacent element portions 12, for example, by emitting a laser from the second surface 14a side. This makes it possible to form a second weak portion W2 in the support substrate 14. Alternatively, before each element portion 12 is bonded to the support substrate 14, the recessed portion 24 such as a notch is formed by an etching method or the like. The cross-sectional shape of the recessed portion 24 is a letter-V shape or a letter-U shape. When the support substrate 14 is divided into individual pieces in the subsequent dividing step, stress is caused to concentrate on the starting point of cleavage at the recessed portion 24 to cause a crack to propagate. This makes it possible to form a cleavage surface.

The material of the support substrate 14 can be selected from semiconductor such as Si, metal such as Cu, or ceramic such as SiN. In a case where the material is semiconductor, the cutting direction of the recessed portion 24 is preferably set to a direction of cleavage. In addition, the cross-sectional shape of the recessed portion 24 is preferably a letter-V shape rather than a letter-U shape because stress is more likely to concentrate on and around the front end of the recessed portion 24, which makes it easy to divide it at an intended location.

The electrode pad 21 described above serving as an n-side electrode is formed on the second surface 14a of the support substrate 14. In addition, as with the electrode pad 21, by using, for example, a lift-off method, an electrode pad 19 serving as an n-side electrode is formed on a surface 13a of the semiconductor element layer 13 that faces the underlying substrate 11. These electrode pads 19 and 21 may be made, for example, of Ti, Al, In, Pd, Au, or the like.

As illustrated in FIG. 13, in the element separation step, the semiconductor element layer 13 is separated from the underlying substrate 11 by using a member including one surface with an adhesive layer 25 made of solder using a material such as Au or AuSn, that is, the support substrate 14, a jig, or the like, and each of them is divided into individual element portions 12.

Note that, for example, after the element separation step and before a step of division into individual pieces, a first weak portion W1 is formed at the semiconductor element layer 13 that has been separated from the underlying substrate 11. Note that the first weak portion W1 can be formed by emitting a laser to form a recessed portion 15 or the like such as a notch extending in a direction (for example, a perpendicular direction) intersecting the resonance direction as illustrated in FIG. 12.

The method for division is performed, for example, in the following manner. First, the support substrate 14 including a joint layer provided on the lower surface thereof is bonded with the second surface 14a facing the first surface 11a of the underlying substrate 11 where the semiconductor element layer 13 is formed. Then, the joint layer is pressed against the semiconductor element layer 13, and heat is applied to perform adhesion. After this, external force is applied in a manner such that the semiconductor element layer 13 integrally bonded with the joint layer is torn off in the upper direction from the underlying substrate 11 to peel the semiconductor element layer 13 off from the first surface 11a of the underlying substrate 11. This makes it possible to separate the semiconductor element layer 13 from the underlying substrate 11 without damaging it, and at the same time, makes it possible to perform cleavage at the weak portions W1 and W2 to obtain individual pieces.

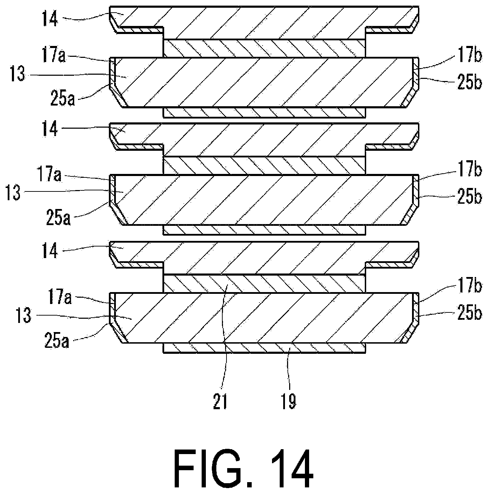

As illustrated in FIG. 14, the plurality of element portions 12 that have been divided into individual pieces are layered, and protection films 25a and 25b made, for example, of AlON are respectively formed on cleavage surfaces 17a and 17b of each of the plurality of element portions 12 that have been divided into individual pieces in the element dividing step described above. There are spaces below or above each semiconductor element layer 13 in the vicinity of the end surfaces of cleavage surface 17a, 17b.

By employing such a configuration, the protection film 25a, 25b is formed on a ridge portion of each element portion 12. Thus, for example, another ingenuity of causing the protective film 25a, 25b to be formed along the semiconductor layer13, such as a method for allowing film formation along the semiconductor layer 13 such as sputtering in a state in which there are spaces above and below the semiconductor element layer 13 is not required. This makes it possible to improve the productivity.

In addition, the second weak portion W2 of the support substrate 14 may further include a thin portion W21. The thin portion W21 is, for example, a portion having a small thickness as compared with the thickness of a portion of the support substrate 14 where the joint layer 22 is disposed. Note that, in this case, a second recessed portion 30 is located above the second surface 14a of the thin portion W21. Thus, the support substrate 14 can be easily divided at the second weak portion W2.

In addition, the width of the first recessed portion 24 may be less than the depth of the first recessed portion 24. Thus, in a case where the second weak portion W2 is formed in the support substrate 14, this makes it further easier to perform the division into individual pieces while maintaining the number of the plurality of semiconductor element layers 13 of the support substrate 14.

Furthermore, a film-shape member 24a may be provided on the inner surface of the first recessed portion 24. Thus, at the time of bonding the joint layer 22, this can reduce the joint layer 22 flowing in the first recessed portion 24. Note that it is only necessary that the film-shape member 24a may be formed, for example, of an oxide film (SiO₂) made of silicon or the like. After the first recessed portion 24 is formed in the support substrate 14, the film-shape member 24a can be formed, for example, by a sputtering method or the like. Note that, in a case where the second weak portion W2 includes the thin portion W21, the film-shape member 24a may be located on the second surface 14a of the thin portion 21. In this case, the front surface of the film-shape member 24a may be located more at an inner side of the support substrate 14 than a second surface (another second surface) 14a where no thin portion W21 is provided. In addition, the second weak portion W2 may include a penetrating portion that extends through in a thickness direction of the support substrate 14. Such a penetrating portion may be formed at regular intervals in a direction in which the second weak portion W2 extends. With this configuration, the force that acts when the semiconductor element layer 13 is divided into individual pieces of the plurality of element portions 12 can be reduced, which makes it possible to improve the yield.

Furthermore, the second weak portion W2 may include only the first recessed portion 24. This makes it possible to maintain the strength of the support substrate 14, which makes it possible to improve ease in handling of the support substrate 14.

In another embodiment, an electrode portion including an n-side electrode and a p-side electrode is formed at each of the layered body 1 described above and individual element portions 12 of the layered body 1. This makes it possible to achieve a semiconductor device such as a light emitting diode or a semiconductor laser element that can be manufactured with high yield, namely, that has excellent productivity.

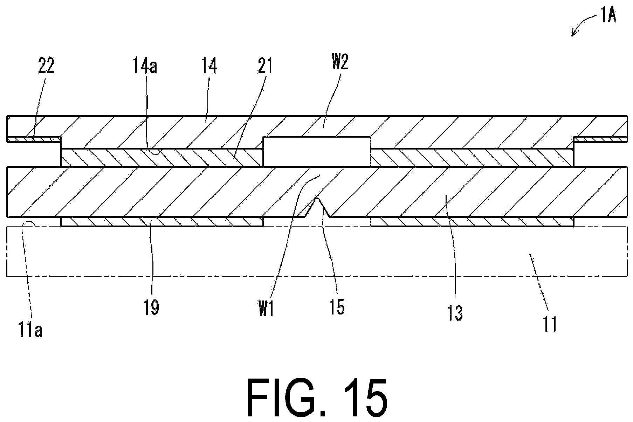

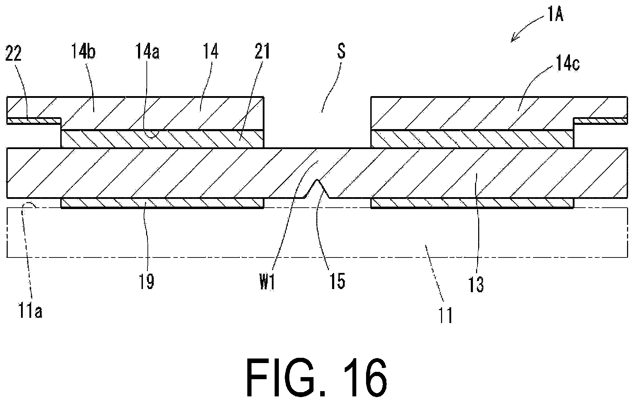

FIG. 15 is a cross-sectional view illustrating a layered body of another embodiment of the present disclosure. FIG. 16 is a cross-sectional view illustrating a layered body of yet another embodiment of the present disclosure. The same reference signs are provided to portions corresponding those in the embodiment described above, and the description thereof is omitted.

A layered body 1A of the present embodiment includes the semiconductor element layer 13 and the support substrate 14. The semiconductor element layer 13 is a single semiconductor element layer 13 dividable into the plurality of element portions 12, and is disposed on the first surface 11a of the underlying substrate 11. In addition, the support substrate 14 includes the second surface 14a that faces the first surface 11a, and the semiconductor element layer 13 is bonded onto the second surface 14a. The semiconductor element layer 13 includes the first weak portion W1 used to divide the semiconductor element layer 13 into individual pieces of the plurality of element portions 12. In the support substrate 14, a portion S that faces the second weak portion W2 is an empty space, and hence, the support substrate 14 does not include a portion that faces the second weak portion W2. That is, the support substrate 14 includes a plurality of support substrate portions 14b and 14c arranged so as to be spaced apart from each other. The plurality of support substrate portions 14b and 14c are configured such that a region between the plurality of support substrate portions 14b and 14c faces the first weak portion W1 of the semiconductor element layer 13.

The first weak portion W1 is a thin portion where the recessed portion 24 is formed. This first weak portion W1 may be formed so as to continuously extend, or the first weak portions W may be formed so as to be spaced apart from each other. The portion S corresponding to the second weak portion W2 of the support substrate 14 of the embodiment described above may be removed, for example, by etching.

In another embodiment, an electrode portion including an n-side electrode and a p-side electrode is formed at each of the layered body 1A described above and individual element portions 12 of the layered body 1A. This makes it possible to achieve a semiconductor device such as a light emitting diode or a semiconductor laser element that can be manufactured with high yield, namely, that has excellent productivity.

Another embodiment of the manufacturing method for a layered body of the present disclosure includes an underlying-substrate preparation step, a support-substrate preparation step, an element-layer formation step, an element-layer bonding step, a weak-portion formation step, and a support-substrate removing step. The underlying-substrate preparation step includes preparing the underlying substrate 11 including the first surface 11a. The support-substrate preparation step includes preparing the support substrate 14 including the second surface 14a that faces the first surface 11a. The element-layer formation step includes forming, on the first surface 11a of the underlying substrate 11, a single semiconductor element layer 13 dividable into the plurality of element portions 12. The element-layer bonding step includes bonding the second surface 14a of the support substrate 14 to the semiconductor element layer 13 formed in the element-layer formation step. The weak-portion formation step includes forming, at the semiconductor element layer 13, the first weak portion W1 used to divide the semiconductor element layer 13 into individual pieces of the plurality of element portions 12. The support-substrate removing step includes removing the portion S of the support substrate 14 that corresponds to the second weak portion W2.

The first weak portion W1 may be formed so as to continuously extend, or may be intermittently formed so that thin portions (recessed portions) are located at a plurality of locations so as to be spaced apart from each other. For example, this configuration makes it possible to reduce the amount of removal substance removed at the time of forming the recessed portions, which makes it possible to make the removal substance less likely to adhere to other portions. This can reduce an influence of the removal substance on the layered body.

In this manner, the first weak portion W1 is formed at the semiconductor element layer 13. This makes shearing stress concentrated on the end portion of the connection portion 23 having a columnar shape at the time of applying pressure in the bonding step, and the connecting portion 23 is sheared. Thus, the semiconductor element layer 13 can be reliably separated from the underlying substrate 11 by simply applying pressure, without the need to separately apply force in a direction perpendicular to the front surface of the underlying substrate 11 with ultrasonic waves or the like, and can be divided into individual pieces of the plurality of element portions 12. In this manner, the semiconductor element layer 13 can be reliably transferred to the support substrate 14 without applying excessive force to the semiconductor element layer 13, and at the same time, can be divided into individual pieces of the plurality of element portions 12. Thus, the yield of the semiconductor element significantly improves, which makes it possible to improve the productivity.

The embodiments of the present disclosure are described in detail. However, the present disclosure is not limited to the embodiments described above, and various modifications or improvements or the like can be made without departing from the main points of the present disclosure.

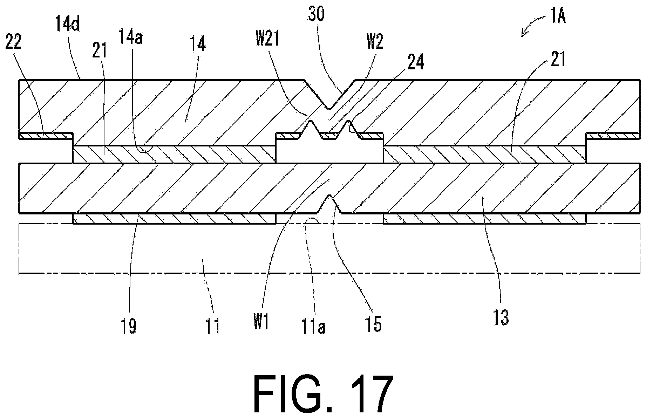

For example, in the example described above, description has been made of an example in which the second weak portion W2 of the support substrate 14 includes one first recessed portion 24. However, the second weak portion W2 of the support substrate 14 may include a plurality of first recessed portions 24 as illustrated in FIG. 17. Thus, the support substrate 14 can be easily divided at the second weak portion W2.

In addition, for example, as illustrated in FIG. 17, the support substrate 14 includes a third surface 14d located on an opposite side of the second surface 14a, and the second weak portion W2 of the support substrate 14 may include the second recessed portion 30 located in the third surface 14d. Thus, the support substrate 14 may be formed so as to have a thickness greater than that of the semiconductor element layer 13. However, even in this case, division into individual pieces can be easily performed.

Note that, in this case, the width of the second recessed portion 30 may be greater than the depth of the second recessed portion 30. Thus, at the time of dividing the support substrate 14 into individual pieces, the support substrate 14 can be divided into individual pieces with the second recessed portion 30 being the starting point by applying force to the second weak portion W2 of the support substrate 14, which makes it possible to easily perform division into individual pieces. In addition, at this time, the second recessed portion 30 may have a width reduced from the opening toward the bottom portion.

In addition, the layered body 1 of the present disclosure may include both the first recessed portion 24 and the second recessed portion 30. This makes it possible to more easily divide the support substrate 14 into individual pieces. Note that, in this case, the width of the second recessed portion 30 may be greater than the width of the first recessed portion 24. In addition, the depth of the second recessed portion 30 may be greater than the depth of the first recessed portion 24. Thus, in a case where the second weak portion W2 is formed at the support substrate 14, this makes it further easier to perform division into individual pieces while maintaining the number of the plurality of semiconductor element layers 13 of the support substrate 14.

Furthermore, the layered body 1 of the present disclosure may include only the second recessed portion 30. This makes it possible to maintain the strength of the support substrate 14, and also makes it possible to improve ease in handling of the support substrate 14 in the subsequent steps.

The present invention can be executed in various modes without departing from its spirit or key characteristics. Accordingly, the foregoing embodiment is merely illustrative in all respects, and the scope of the present invention is as set forth in the claims and is in no way limited by the specification. Furthermore, any variations or modifications that fall within the scope of the claims are also within the scope of the present invention.

### Reference Signs List

1, 1A Layered body
2 Divided piece
11 Underlying substrate
11a First surface
12 Element portion
13 Semiconductor element layer
14 Support substrate
14a Second surface
W, W1, W2 Weak portion
15, 24 Recessed portion
17a, 17b Cleavage surface
18 Mask layer
19, 21 Electrode pad
20 Protective layer
22 Joint layer
23 Connection portion
25a, 25b Protection film

## Claims

1. A layered body, comprising:
an underlying substrate comprising a first surface;
a semiconductor element layer that is a single semiconductor element layer dividable into a plurality of element portions, the semiconductor layer being located on the first surface of the underlying substrate; and
a support substrate comprising a second surface on which the semiconductor element layer is located, the second surface facing the first surface, wherein
the support substrate and the semiconductor element layer comprise a weak portion used to divide the semiconductor element layer into the plurality of element portions.

2. The layered body according to claim 1, wherein
the weak portion is a thin portion comprising a recessed portion.

3. The layered body according to claim 1 or 2, wherein
a thin portion of the weak portion continuously extends in a direction intersecting a resonance direction.

4. The layered body according to any one of claims 1 to 3, wherein
a thin portion of the weak portion extends intermittently with a gap being provided in a direction intersecting a resonance direction.

5. A semiconductor device comprising:
the layered body according to any one of claims 1 to 4; and
an electrode portion located at each of the plurality of element portions of the layered body.

6. The layered body according to any one of claims 1 to 5, wherein
the weak portion of the support substrate comprises a first recessed portion located in the second surface.

7. The layered body according to claim 6, wherein
the weak portion of the support substrate comprises a plurality of first recessed portions located in the second surface.

8. The layered body according to claim 6 or 7, wherein
a width of the first recessed portion is less than a depth of the first recessed portion.

9. The layered body according to any one of claims 6 to 8, wherein
the first recessed portion comprises an opening, a bottom surface, and a side surface connected to the bottom surface and extending to the opening, and
a film-shape member is provided on the bottom surface.

10. The layered body according to any one of claims 1 to 9, wherein
the support substrate comprises a third surface located on an opposite side of the second surface, and
the weak portion of the support substrate comprises a second recessed portion located on the third surface.

11. The layered body according to claim 10, wherein
a width of the second recessed portion is greater than a depth of the second recessed portion.

12. The layered body according to claim 10 or 11, wherein
the second recessed portion has a width reduced from the opening toward the bottom portion.

13. The layered body according to any one of claims 1 to 12, wherein
the support substrate comprises a third surface located on an opposite side of the second surface,
the weak portion of the support substrate comprises a first recessed portion located in the second surface and a second recessed portion located in the third surface, and
a width of the second recessed portion is greater than a width of the first recessed portion.

14. The layered body according to claim 13, wherein
a depth of the second recessed portion is greater than a depth of the first recessed portion.

15. The layered body according to any one of claims 1 to 14, wherein
the weak portion of the support substrate comprises a penetrating portion.

16. A layered body comprising:
an underlying substrate comprising a first surface;
a semiconductor element layer that is a single semiconductor element layer dividable into a plurality of element portions, the semiconductor element layer being located on the first surface of the underlying substrate; and
a support substrate comprising a second surface on which the semiconductor element layer is located, the second surface facing the first surface, wherein
the semiconductor element layer comprises a weak portion used to divide the semiconductor element layer into the plurality of element portions,
the support substrate comprises a plurality of support substrate portions spaced apart from each other, and
the plurality of support substrate portions are provided in a manner such that a region between the plurality of support substrate portions faces the weak portion.

17. A manufacturing method for a layered body, comprising:
preparing an underlying substrate comprising a first surface;
preparing a support substrate comprising a second surface facing the first surface;
forming, on the first surface of the underlying substrate, a semiconductor element layer that is a single semiconductor element layer dividable into a plurality of element portions;
bonding the second surface of the support substrate to the semiconductor element layer formed in the forming the single semiconductor element layer; and
forming a weak portion used to divide the semiconductor element layer into the plurality of element portions at each of the semiconductor element layer and the support substrate that are bonded in the bonding the second surface.

18. The manufacturing method for a layered body according to claim 17, wherein
a thin portion of the weak portion continuously extends in a direction intersecting a resonance direction.

19. The manufacturing method for a layered body according to claim 17, wherein
a thin portion of the weak portion extends intermittently with a gap being provided in a direction intersecting a resonance direction.

20. The manufacturing method for a layered body according to any one of claims 17 to 19, wherein
the weak portion of the support substrate comprises a penetrating portion.
